# FASCICULE DE BREVET EUROPEEN

(11) **EP 1 017 103 B1**
(45) Date de publication et mention de la délivrance du brevet: **28.05.2008**
(21) Numéro de dépôt: 99410186.3
(22) Date de dépôt: 28.12.1999
(51) Int. Cl.: H01L 27/06

(54) **Interrupteur de puissance à DI/DT contrôle**
Leistungsschalter mit DI/DT Regelung
Power switch with DI/DT control

(30) Priorité: 31.12.1998 FR 9816771
(43) Date de publication de la demande: 05.07.2000
(73) Titulaire: STMicroelectronics S.A., 92120 Montrouge (FR)
(72) Inventeur: Jalade, Jean, 31320 Castanet-Tolosan (FR); Sanchez, Jean-Louis, 31750 Escalquens (FR); Laur, Jean-Pierre, 81000 Albi (FR); Breil, Marie, 31400 Toulouse (FR); Austin, Patrick, 31240 L'Union (FR); Bernier, Eric, 37390 Mettray (FR); Roy, Mathieu, 37300 Joue les Tours (FR)
(74) Mandataire: de Beaumont, Michel

(56) Documents cités:
- EP-A- 0 559 945
- WO-A-99/17374
- LENDENMANN H ET AL: "SWITCHING BEHAVIOR AND CURRENT HANDLING PERFORMANCE OF MCT-IGBT CELL ENSEMBLES" PROCEEDINGS OF THE INTERNATIONAL ELECTRON DEVICES MEETING, WASHINGTON, DEC. 8 - 11, 1991,8 décembre 1991 (1991-12-08), pages 91/149-152, XP000342115 INSTITUTE OF ELECTRICAL AND ELECTRONICS ENGINEERS ISBN: 0-7803-0243-5
- PATENT ABSTRACTS OF JAPAN vol. 097, no. 001, 31 janvier 1997 (1997-01-31) -& JP 08 241980 A (FUJI ELECTRIC CO LTD), 17 septembre 1996 (1996-09-17)
- PATENT ABSTRACTS OF JAPAN vol. 012, no. 246 (E-632), 12 juillet 1988 (1988-07-12) -& JP 63 036568 A (TOSHIBA CORP), 17 février 1988 (1988-02-17)

## Description

La présente invention concerne le domaine de la régulation de puissance. Pour contrôler le fonctionnement d'équipements industriels et domestiques, on utilise souvent des composants semiconducteurs de puissance fonctionnant en commutation. On réalise ainsi des commandes dites à contrôle de l'angle de conduction (ou à contrôle de phase) dans lesquelles un interrupteur de puissance n'est rendu passant que pendant une partie de la durée de chaque alternance ou d'une alternance sur deux de la tension d'alimentation. De tels systèmes sont couramment utilisés dans le domaine de l'éclairage domestique pour réaliser des variateurs de lumière, et dans de nombreuses autres applications pour constituer des variateurs de puissance.

La régulation de puissance par commande d'angle de conduction présente l'inconvénient bien connu de générer sur le secteur des harmoniques dus au fait que l'interrupteur se ferme tandis qu'il existe une tension relativement importante à ses bornes. Ces harmoniques provoquent des perturbations électromagnétiques et constituent un problème majeur. Diverses normes ont été développées pour imposer aux fabricants d'éviter la génération de telles perturbations. Un moyen simple pour éviter la réinjection d'harmoniques sur le secteur consiste à les filtrer. Néanmoins, l'addition d'un filtre passif à un variateur constitue un handicap sérieux en terme d'encombrement, de poids et de coût. Pour éviter ce filtre, on a envisagé également d'attaquer le problème à la base en maîtrisant la vitesse de variation du courant (di/dt) lors des commutations. Hélas, ni le thyristor ni le triac - qui sont des composants idéaux pour fabriquer un variateur en raison de leur robustesse, de leur tenue aux surcharges, de leur facilité de commutation et de leur faible puissance dissipée à l'état passant - ne permettent ce contrôle du di/dt.

On a donc proposé dans l'art antérieur par exemple dans le document EP-A-559945, d'utiliser des systèmes du type représenté schématiquement en figure 1 qui comprennent en parallèle des composants de puissance 1 et 2. Le composant 1 est un composant tel que la variation du courant principal à la fermeture est liée à la variation de la tension de commande, par exemple un transistor MOS de puissance ou un transistor bipolaire à commande par une grille isolée (IGBT). Le composant 2 est un composant du type thyristor ou triac qui a l'avantage, une fois en conduction, de présenter une très faible chute de courant à l'état passant et qui de plus a l'avantage de s'éteindre automatiquement quand le courant qui le traverse devient sensiblement nul. Ainsi, on a cherché à réaliser des interrupteurs tels que la fermeture est produite par un composant du type du composant 1 tandis que la plus grande partie de la phase de conduction et l'ouverture sont assurées par un composant du type du composant 2. Il est en conséquence prévu un circuit de commande 3 pour provoquer la mise en conduction du deuxième composant, du type thyristor, une fois que le premier composant, du type transistor MOS ou IGBT, a été rendu passant.

Etant donné qu'un transistor de puissance de type MOS ou IGBT est un composant à structure multicellulaire, on a généralement tenté d'associer à chacune des cellules du composant MOS une structure ayant la fonction thyristor. On se trouve donc avec une structure d'ensemble du type multicellulaire.

La présente invention est basée sur la prise de conscience par les inventeurs du fait que de telles structures de type multicellulaire présentent divers inconvénients. Un premier inconvénient est que, pour un courant maximum donné, un thyristor de type multicellulaire aura inévitablement une surface plus grande qu'un thyristor monocellulaire. Un autre inconvénient est que les connexions sont souvent plus difficiles à réaliser entre diverses cellules d'un composant multicellulaire qu'avec des composants monocellulaires, ce qui oblige à augmenter le nombre de niveaux de métallisation.

Ainsi, un objet de la présente invention est de prévoir un circuit et une structure d'interrupteur à di/dt contrôlé qui associe à un transistor MOS ou IGBT de type multicellulaire un composant de puissance monocellulaire de type thyristor, de façon à obtenir un composant de surface minimale pour un courant maximum donné.

Pour atteindre ces objets, la présente invention prévoit un interrupteur de puissance monolithique à di/dt contrôlé comprenant le montage en parallèle d'un composant de type MOS ou IGBT et d'un composant de type thyristor, comprenant des moyens pour inhiber le composant de type thyristor pendant la phase de fermeture de l'interrupteur qui est assurée par le composant de type IGBT. Le composant de type IGBT est réalisé sous forme d'une structure verticale multicellulaire et le composant de type thyristor sous forme d'une structure verticale monocellulaire.

Selon un mode de réalisation de la présente invention, l'interrupteur est formé dans un substrat d'un premier type de conductivité dont la face arrière comporte une région du deuxième type de conductivité. Ce composant comprend du côté de la face supérieure des premières cellules de type MOS ou IGBT vertical, des deuxièmes cellules de type MOS ou IGBT vertical et un caisson de gâchette de cathode du deuxième type de conductivité contenant une région de cathode d'un thyristor principal et une région de cathode d'un thyristor auxiliaire. La région de cathode des deuxièmes cellules est reliée aux régions de cathode et de gâchette de cathode du thyristor auxiliaire, les régions de cathode et de gâchette de cathode du thyristor principal sont reliées à une borne de cathode et la zone dudit caisson comprise entre les régions de cathode des thyristors principal et auxiliaire est revêtue d'une grille isolée.

Selon un mode de réalisation de la présente invention, l'interrupteur est formé dans un substrat d'un premier type de conductivité dont la face arrière comporte une région du deuxième type de conductivité. Ce composant comprend du côté de la face supérieure des premières cellules de type MOS ou IGBT vertical, et des deuxièmes cellules combinant des structures de type MOS ou IGBT vertical et une structure de thyristor auxiliaire vertical, ces deuxièmes cellules étant formées dans des régions du deuxième type de conductivité et contenant deux anneaux du premier type de conductivité, le premier anneau étant séparé du second par une première grille isolée et étant relié à la partie centrale de ladite région par une métallisation, et le second anneau étant séparé de la périphérie de ladite région par une seconde grille isolée reliée à la grille des premières cellules.

Selon un mode de réalisation de la présente invention, l'interrupteur comprend en outre une diode de type vertical polarisée de façon inverse du thyristor.

Selon un mode de réalisation de la présente invention, les moyens d'inhibition comprennent un transistor MOS connecté entre gâchette et cathode du thyristor.

Selon un mode de réalisation de la présente invention, l'interrupteur comprend des moyens d'auto-polarisation du transistor MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un schéma général classique d'un interrupteur à di/dt contrôlé ;
la figure 2 représente sous forme schématique un circuit que la présente invention vise à mettre en oeuvre ;
la figure 3 est une autre représentation du circuit de la figure 2 ;
la figure 4 représente des signaux de commande d'un composant selon la présente invention ;
la figure 5 représente un autre circuit que la présente invention vise à mettre en oeuvre ;
la figure 6 est une vue en coupe schématique d'un mode de réalisation d'un composant monolithique mettant en oeuvre le circuit des figures 2 et 3 ;
la figure 7 est un exemple de vue de dessus du composant de la figure 6 ;
la figure 8 est une vue en coupe schématique d'un mode de réalisation d'un composant monolithique mettant en oeuvre le circuit de la figure 5 ;
la figure 9 est une vue en coupe schématique d'un autre mode de réalisation d'un composant monolithique mettant en oeuvre le circuit des figures 2 et 3 ;
la figure 10 représente un assemblage en série et en opposition de deux interrupteurs selon la présente invention ; et
la figure 11 illustre une variante de commande d'un interrupteur selon la présente invention.

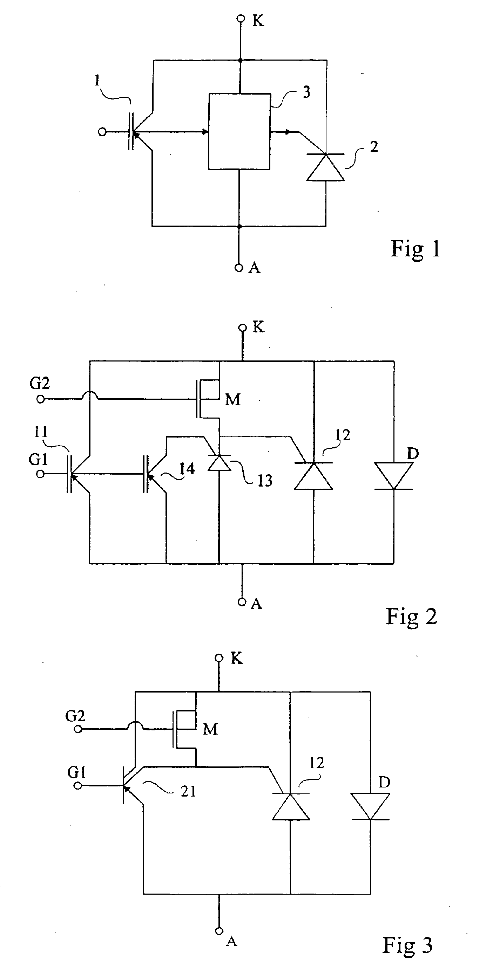

La figure 2 représente un exemple de circuit d'interrupteur à di/dt contrôlé selon la présente invention. Cet interrupteur comprend un transistor de puissance de type IGBT 11 (transistor bipolaire à grille isolée) et un thyristor de puissance 12. Ces deux composants sont connectés en parallèle entre une anode A et une cathode K. L'anode du thyristor 12 et l'anode de l'IGBT 11 sont connectées à l'anode A. La cathode du thyristor 12 et la cathode de l'IGBT 11 sont connectées à la cathode K. Dans ce mode de réalisation, une diode D est connectée en antiparallèle sur le thyristor 12 entre les bornes A et K. L'IGBT 11 est relié à une première borne de commande par sa grille G1. Les composants 11 et 12 sont interconnectés par un circuit de commande comprenant un thyristor pilote 13 dont l'anode est reliée à l'anode du thyristor 12 et dont la cathode est reliée à la gâchette du thyristor 12. La cathode du thyristor 13 est reliée à la cathode K par l'intermédiaire d'un transistor MOS M dont la grille G2 est reliée à une deuxième borne de commande. La gâchette du thyristor 13 est reliée à son anode par l'intermédiaire d'un deuxième IGBT 14 dont la grille est reliée à la borne G1. On comprendra que les composants M, 13 et 14 sont des composants de faible puissance et donc de faible surface devant les composants 11, 12 et D.

La figure 3 constitue une autre illustration du circuit de la figure 2. On y retrouve la diode D, le thyristor 12 et le transistor MOS M. L'ensemble IGBT 11, IGBT 14 et thyristor pilote 13 est remplacé par un IGBT 21 à deux cathodes dont la première est reliée comme dans la figure précédente et dont la deuxième est reliée directement à la gâchette du thyristor 12.

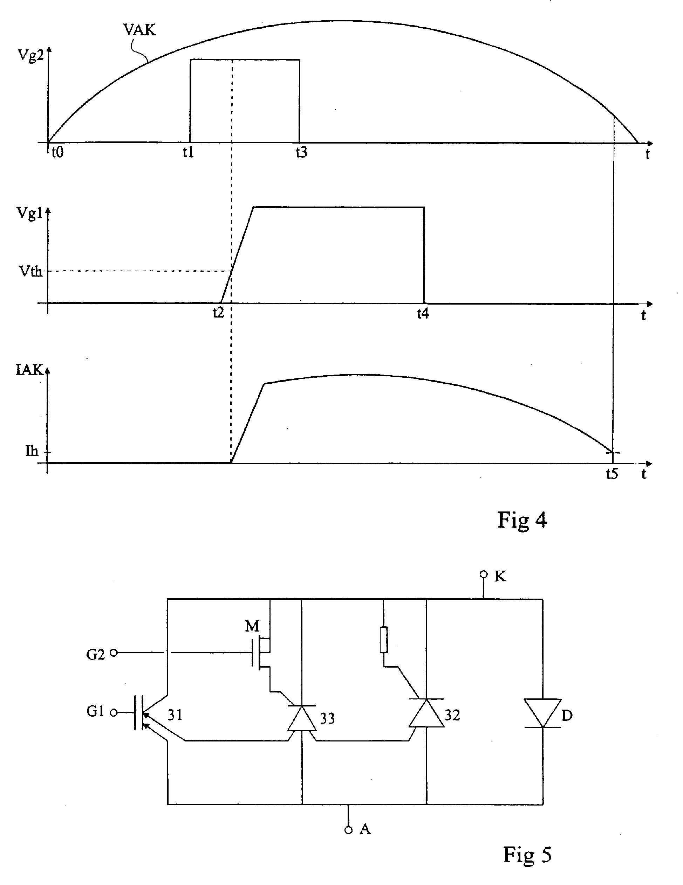

Le fonctionnement du circuit de la figure 2 ou 3 va être expliqué en relation avec la figure 4 qui représente la tension Vg2 sur la grille G2, la tension Vg1 sur la grille G1 et le courant I_{AK} entre l'anode A et la cathode K. On considère une alternance positive de la tension V_{AK} entre les bornes A et K.

A un instant t1, peu postérieur au début t0 d'une alternance positive de la tension du secteur, on commande la grille G2 du transistor M pour rendre celui-ci conducteur, de sorte que la gâchette et la cathode du thyristor 12 sont court-circuitées et que ce thyristor ne peut pas rentrer en conduction. A un instant t2, postérieur à l'instant t1 et choisi en fonction de l'angle de conduction désiré, on applique sur la gâchette G1 du transistor 11 une rampe de tension dont la pente est contrôlée de façon à obtenir le di/dt souhaité. Cette rampe résulte par exemple de l'application d'un signal en créneau à travers un filtre RC (de faible puissance puisqu'il s'agit d'un signal de commande). Dès que la tension sur la borne G1 dépasse une valeur de seuil Vth, le courant I_{AK} se met à croître progressivement jusqu'à une valeur correspondant à une pleine conduction. Ensuite, à un instant t3, on coupe le signal sur la grille G2 pour bloquer le transistor M et le courant de cathode de l'IGBT 14 (ou de la cathode auxiliaire de l'IGBT 21) déclenche le thyristor 13 (ou 12). Le thyristor 12 devient passant et sa conduction domine celle de l'IGBT 11 ou 21 puisque, de façon générale, un thyristor présente une chute de tension plus faible qu'un transistor de puissance MOS ou IGBT. Ensuite, à un instant t4 on coupe le signal sur la grille G1, de sorte que les IGBT 11 et 14 se bloquent définitivement. Ainsi, à la fin de l'alternance, à l'instant t5, quand la tension V_{AK} devient trop faible, le courant I_{AK} passe en dessous d'une valeur de seuil Ih et le thyristor se rebloque. C'est pour éviter la remise en conduction de l'IGBT que l'on a interrompu la tension de grille G1.

La figure 5 représente un autre mode de réalisation possible de la présente invention dans lequel on utilise des thyristors à gâchette d'anode plutôt que des thyristors à gâchette de cathode. Dans ce circuit, on retrouve la diode inverse D. Le thyristor principal à gâchette de cathode 12 est remplacé par un thyristor principal à gâchette d'anode 32. Le thyristor pilote à gâchette de cathode 13 est remplacé par un thyristor à gâchette d'anode 33 et on utilise un IGBT 31 dont l'anode sert également de gâchette d'anode du thyristor pilote 33. La gâchette de cathode du thyristor pilote est reliée à sa cathode par l'intermédiaire d'un transistor MOS à canal N à enrichissement M.

Selon un avantage de la présente invention, les circuits décrits d'une part en figures 2 et 3, d'autre part en figure 5, permettent des réalisations sous forme de composants monolithiques.

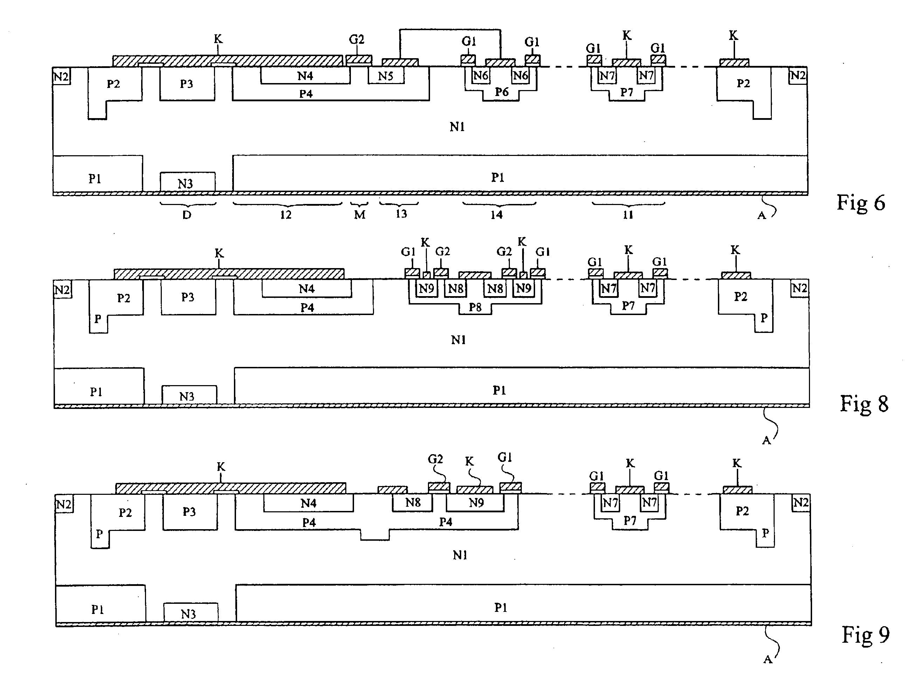

La figure 6 représente une réalisation possible du circuit de la figure 2 ou 3. Le composant est formé dans une tranche de silicium de type N, N1. A la périphérie de cette tranche, du côté de la face supérieure, on trouve tout à fait à l'extérieur, un anneau N2 de type N puis, un peu plus à l'intérieur, un anneau P2 de type P connecté à la cathode K. Il s'agit là d'un système classique de tenue en tension. Du côté de la face arrière, en face des régions N2 et P2, est formée une couche P1 fortement dopée de type P.

La diode D correspond à une région P3 formée du côté de la face avant, en face de laquelle se trouve du côté de la face arrière une région N3 fortement dopée de type N. Le thyristor principal 12 comprend du côté de la face supérieure une région N4 de type N formée dans un caisson P4 de type P. Du côté de la face arrière, de même que pour tous les composants que l'on mentionnera ci-après, se trouve la région P1 de type P. La seule région de type N de la face arrière est la région N3 susmentionnée de cathode de la diode D. On a donc formé un thyristor principal N4-P4-N1-P1. Le thyristor auxiliaire 13 est un thyristor vertical dont la cathode correspond à une région N5 de type N également formée dans le caisson P4. Ainsi, le thyristor auxiliaire 13 comprend les régions N5-P4-N1-P1. Une partie au moins de la région P4 entre les régions N4 et N5 est revêtue d'une grille isolée G2, les régions N4-P4-N5 correspondant au transistor MOS à canal N à enrichissement M. L'IGBT 14 est un composant multicellulaire dont chaque cellule comprend de façon classique une région annulaire de source N6 formée dans un caisson P6. La périphérie du caisson P6, entre la région N6 et l'extérieur de ce caisson P6, est recouverte d'une grille G1 comme cela est classique. Ainsi, étant donné que la face arrière est revêtue d'une couche P1 de type P, on a formé un IGBT vertical, dont la cathode correspond à une métallisation formée sur les régions P6 et N6, dont la grille correspond à la métallisation G1 et dont l'anode correspond à la face arrière du composant. De même, l'IGBT principal 11 comprend des cellules dont chacune comporte dans un caisson P7 une région annulaire de source N7.

Une première métallisation de face supérieure reliée à la borne K recouvre les régions P2, P3, N4 et N7-P7. Cette métallisation K recouvre aussi une partie du caisson P4 opposée à la grille G2. Une autre métallisation de face supérieure, non connectée à une source externe, recouvre la région N5 et une partie du caisson P4 éloignée de la grille G2 ainsi que les caissons P6 et les sources N6.

On notera que l'IGBT 11 de la figure 2 correspond à un grand nombre de cellules formées dans des caissons P7, que l'IGBT 14 correspond à un plus petit nombre de cellules formées dans des caissons P6, mais que les thyristors 12 et 13, le MOS M et la diode D sont des composants monocellulaires.

Dans une étape initiale, à partir de l'instant t2 où les grilles G1 et G2 sont polarisées, les cellules correspondant aux caissons P7 sont passantes. En ce qui concerne les cellules correspondant aux caissons P6, la conduction se fait à partir de l'anode A vers la métallisation recouvrant les sources N6, vers la région N5 puis vers la région N4 et la cathode K puisque, du fait de la polarisation de la grille G2, on peut considérer que les régions N4 et N5 sont connectées l'une à l'autre. Pendant cette phase, la conduction des thyristors est inhibée.

A partir de l'instant t3, quand la grille G2 n'est plus polarisée, le courant ne peut plus circuler de la région N5 à la région N4 par l'intermédiaire du canal formé sous la grille G2 mais se referme en passant par la région P4 sous les régions N4 et N5. Cette circulation de courant provoque successivement le déclenchement des thyristors N5-P4-N1-P1 et N4-P4-N1-P1. A partir du moment où ce dernier thyristor se déclenche, l'essentiel du courant le traverse. On veillera à ce que les IGBT ne présentent pas une résistance à l'état passant trop faible pour ne pas retarder ou inhiber le déclenchement des thyristors.

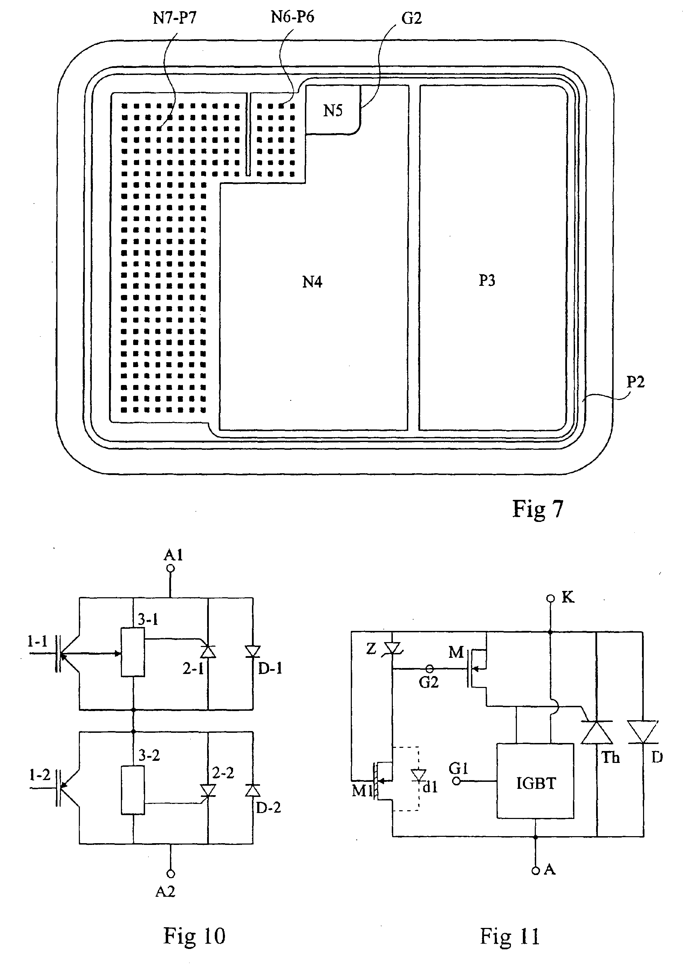

La figure 7 représente une vue de dessus très schématique d'un mode de réalisation du circuit de la figure 6. De mêmes éléments sont désignés par de mêmes références. Cette figure a essentiellement pour but de faire ressortir la nature monocellulaire des éléments D, 12, M et 13 et la nature multicellulaire des IGBT 11 et 14. Les cellules des IGBT sont représentées très symboliquement par des carrés noirs. La grille G1 s'étend entre ces cellules. Par contre, la grille G2 est représentée sous forme d'un simple trait séparant les régions N4 et N5.

La figure 8 représente un mode de réalisation monolithique du circuit de la figure 5. La périphérie du composant, la diode D (P3-N1-N3) et le thyristor principal N4-P4-N1-P1 ont la même structure qu'en figure 6. De même, l'IGBT principal, constitué du côté de la face supérieure de cellules P7-N7, est identique à celui de la figure 6. Le circuit intermédiaire de transfert de conduction de l'IGBT au thyristor est par contre différent. Il est formé dans un caisson P8 et comprend dans ce caisson deux anneaux successifs de type N, N8 et N9. Les régions N8 et les parties centrales des caissons P8 sont reliées à une métallisation non connectée à une borne extérieure tandis que les régions N9 sont connectées à la cathode K. La zone comprise entre l'extérieur de l'anneau externe N9 et la périphérie externe du caisson P8 est revêtue d'une grille G1. L'intervalle entre les régions annulaires N8 et N9 est revêtu d'une grille G2. Les grilles G1 et G2 sont commandées comme cela a été décrit en relation avec les figures 4 et 6.

Comme précédemment, dans un état initial, quand les grilles G1 et G2 sont polarisées, l'IGBT principal correspondant aux cellules N7-P7 est passant et les cellules correspondant aux caissons P8 sont également passantes. Quand le signal appliqué sur la grille G2 est interrompu, le court-circuit entre la cathode N9 et la base P8 est supprimé et le thyristor auxiliaire N8-P8-N1-P1 devient passant. Si ce thyristor est suffisamment proche du thyristor principal, l'injection au niveau de la jonction P1-N1 entraîne également la mise à l'état passant du thyristor principal N4-P4-N1-P1 qui se déclenche ici en mode de gâchette d'anode.

La figure 9 illustre une structure qui se rapproche de celle de la figure 8, mais dans laquelle la commande du thyristor principal est du type à gâchette de cathode. La structure de la figure 9 correspond à une modification de la structure de la figure dans laquelle les caissons P8, au lieu de constituer de multiples cellules constituent un prolongement périphérique du caisson P4. Dans ce caisson P4 sont formées des zones périphériques distinctes N8 et N9, la zone N9 étant la plus externe. Une grille isolée G1 surmonte la périphérie du caisson P4, à l'extérieur de la zone N9. La zone N9 est reliée à la métallisation K. Une grille G2 s'étend entre les zones N8 et N9. Une métallisation relie la zone N8 au caisson P4, du côté de la région N4.

Le fonctionnement de la structure de la figure 9 est similaire à celui de la figure 8 quand les grilles G1 et G2 provoquent un état passant. Quand le signal sur la grille G2 est interrompu, le court-circuit entre la cathode N9 et la base P4 est interrompu et le thyristor de couplage N9-P4-N1-P1 devient passant. La génération de porteurs dans la base P4 entraîne alors la mise en conduction du thyristor principal N4-P4-N1-P1.

La figure 10 représente la connexion en série et en opposition, entre deux bornes A1 et A2, de deux composants selon la présente invention pour constituer un interrupteur bidirectionnel à di/dt contrôlé. On voit dans ce cas tout l'intérêt de prévoir les diodes inverses D. Le composant supérieur, polarisé comme les composants décrits précédemment, comprend un IGBT principal 1-1, un thyristor principal 2-1, une diode inverse D-1 et un circuit de commande 3-1 constitué de l'une ou l'autre des façons décrites précédemment. Le composant inférieur comprend des éléments correspondants 1-2, 2-2, 3-2 et D-2 polarisés en inverse. Ainsi, quand la borne A1 est positive, la conduction se fait par la diode D-1 puis par l'intermédiaire du composant inférieur. Quand la borne A1 est négative, la connexion se fait par la diode D-2 puis par l'intermédiaire du composant supérieur.

Dans ce qui précède, pour un fonctionnement en alternatif, on a décrit en relation avec la figure 10 l'association en série et en opposition de deux composants comprenant chacun une diode en anti-parallèle. Ce type d'association de composants est actuellement préféré car les transistors de type IGBT supportent généralement difficilement une tension inverse relativement élevée. Par contre, si, avec l'évolution des technologies, on arrive à fabriquer à des coûts raisonnables des transistors de type IGBT à tenue en inverse suffisante, on pourra simplement placer deux composants selon la présente invention, sans la diode inverse D, en anti-parallèle pour constituer un dispositif de commande en courant alternatif.

Une variante de la présente invention est illustrée de façon schématique en figure 11. Dans ce qui a été décrit précédemment, l'interrupteur selon la présente invention comprend deux bornes de commande G1 et G2, la borne de commande G1 étant celle qui sert à fixer le rapport cyclique de conduction de l'interrupteur et la borne G2 étant une borne fonctionnelle uniquement destinée à bloquer le composant de type thyristor au début de chaque alternance. On peut prévoir que le signal sur la borne G2 est fourni de façon automatique par des composants facilement intégrables dans la structure monolithique incorporant les autres composants constituant l'interrupteur selon la présente invention. Un exemple schématique d'un circuit assurant cette fonction est illustré en figure 11.

En figure 11, la diode D est la même que celle des figures 2, 3 et 5, le thyristor Th représente de façon symbolique les thyristors 12 et 13 de la figure 2, le thyristor 12 de la figure 3, ou les thyristors 32 et 33 de la figure 5. Le bloc IGBT correspond à l'ensemble des éléments 11 et 14 de la figure 2, à l'élément 21 de la figure 3, ou à l'élément 31 de la figure 5. L'originalité du circuit de la figure 11 réside dans le mode de connexion de la borne de grille G2 du thyristor MOS M servant à évider la conduction du thyristor Th dans une phase initiale. Selon cette variante de l'invention, la grille G2 est connectée à un système d'auto-polarisation, destiné à assurer la mise en conduction du transistor M dans une phase initiale de chaque alternance de tension appliquée entre les bornes A et K. Ce système de polarisation automatique comprend par exemple, comme cela est représenté, la connexion en série entre les bornes A et K d'un transistor MOS à déplétion M1 et d'une diode zener Z. La grille du transistor M1 est connectée à la borne K. Ainsi, quand la tension sur la borne K part d'une valeur nulle, et commence à croître, le transistor M1 conduit et charge la grille du transistor M. Dès que la tension VAK devient supérieure à la tension de seuil Vth_{M} du transistor M, ce transistor conduit et court-circuite la jonction gâchette-cathode du thyristor Th. Ce thyristor doit ne pas être trop sensible pour ne pas s'amorcer avant cette mise en conduction du transistor M. La diode zener Z a une fonction de protection et assure que la tension sur la grille M ne dépasse pas une valeur déterminée. Ensuite, comme cela a été décrit précédemment, une fois qu'une tension de commande est appliquée sur la grille G1, le transistor IGBT devient passant et la tension entre les bornes A et K chute à une valeur faible, qui devient inférieure à la tension de seuil Vth_{M}. A titre d'exemple, on pourra atteindre des valeurs de saturation telles que VAK soit de l'ordre de 1,5 à 2 volts tandis que Vth_{M} pourra être choisi à une valeur de l'ordre de 3 à 4 volts. La capacité grille-source du transistor M se décharge alors à travers la diode structurelle d1 en anti-parallèle sur le transistor MOS M1, ce qui bloque le transistor M et permet à la gâchette du thyristor Th d'être alimentée et, comme cela a été décrit précédemment, la conduction est maintenant assurée par le thyristor Th plutôt que par l'IGBT. Bien entendu, cette structure est susceptible de diverses variantes. Par exemple, le transistor à appauvrissement M1 peut être remplacé par une résistance non-linéaire. Il est alors nécessaire de prévoir une diode en anti-parallèle réelle d1.

Bien entendu, la présente invention est susceptible de diverses variantes et modifications qui apparaîtront à l'homme de l'art. En particulier, tous les types de conductivité décrits précédemment pourront être inversés, les polarisations étant modifiées de façon correspondante. D'autre part, diverses variantes connues pourront être apportées à chacun des composants décrits précédemment du moment qu'ils assurent la même fonction que celle qui a été mentionnée ci-dessus.

## Revendications

1. Interrupteur de puissance monolithique à di/dt contrôlé comprenant le montage en parallèle d'un composant (11, 21, 31) de type MOS ou IGBT et d'un composant (12, 32) de type thyristor, comprenant des moyens (M) pour inhiber le composant de type thyristor pendant la phase de fermeture de l'interrupteur qui est assurée par le composant de type IGBT, **caractérisé en ce que** le composant de type IGBT est réalisé sous forme d'une structure verticale multicellulaire et le composant de type thyristor sous forme d'une structure verticale monocellulaire.

2. Interrupteur de puissance monolithique selon la revendication 1, formé dans un substrat (N1) d'un premier type de conductivité dont la face arrière comporte une région (P1) du deuxième type de conductivité, **caractérisé en ce qu'**il comprend du côté de la face supérieure des premières cellules (N7, P7) de type MOS ou IGBT vertical, des deuxièmes cellules (N6, P6) de type MOS ou IGBT vertical et un caisson de gâchette de cathode du deuxième type de conductivité (P4) contenant une région de cathode (N4) d'un thyristor principal et une région de cathode (N5) d'un thyristor auxiliaire, dans lequel la région de cathode des deuxièmes cellules est reliée aux régions de cathode et de gâchette de cathode du thyristor auxiliaire, les régions de cathode et de gâchette de cathode du thyristor principal sont reliées à une borne de cathode (K) et la zone dudit caisson (P4) comprise entre les régions de cathode des thyristors principal et auxiliaire est revêtue d'une grille isolée (G2).

3. Interrupteur de puissance monolithique selon la revendication 1, formé dans un substrat (N1) d'un premier type de conductivité dont la face arrière comporte une région (P1) du deuxième type de conductivité, **caractérisé en ce qu'**il comprend du côté de la face supérieure des premières cellules (N7-P7) de type MOS ou IGBT vertical, et des deuxièmes cellules combinant des structures de type MOS ou IGBT vertical et une structure de thyristor auxiliaire vertical, ces deuxièmes cellules étant formées dans des régions du deuxième type de conductivité (P8) et contenant deux anneaux du premier type de conductivité, le premier anneau (N8) étant séparé du second par une première grille isolée (G2) et étant relié à la partie centrale de ladite région par une métallisation, et le second anneau (N9) étant séparé de la périphérie de ladite région par une seconde grille isolée (G1) reliée à la grille des premières cellules.

4. Interrupteur selon la revendication 2 ou 3, **caractérisé en ce qu'**il comprend en outre une diode de type vertical (D ; P3-N1-N3) polarisée de façon inverse du thyristor.

5. Interrupteur de puissance monolithique selon la revendication 1, **caractérisé en ce que** les moyens d'inhibition (M) comprennent un transistor MOS connecté entre gâchette et cathode du thyristor.

6. Interrupteur de puissance monolithique selon la revendication 5, **caractérisé en ce qu'**il comprend des moyens (M1, Z) d'auto-polarisation du transistor MOS.

## Claims

1. A monolithic power switch with a controlled di/dt including the parallel assembly of a MOS or IGBT type component (11, 21, 31) with a thyristor type component (12, 32), including means (M) for inhibiting the thyristor type component during the closing phase of the switch, which is ensured by the IGBT type component, **characterized in that** the IGBT type component is made as a vertical multicell structure and the thyristor type component has a vertical monocell structure.

2. The monolithic power switch of claim 1, formed in a substrate (N1) of a first conductivity type, the rear surface of which includes a region (P1) of the second conductivity type, **characterized in that** it includes on the upper surface side first cells (N7, P7) of vertical MOS or IGBT type, second cells (N6, P6) of vertical MOS or IGBT type, and a cathode gate well of the second conductivity type (P4) containing a cathode region (N4) of a main thyristor and a cathode region of an auxiliary thyristor, wherein the cathode region of the second cells is connected to the cathode and cathode-gate regions of the auxiliary thyristor, the cathode and cathode gate regions of the main thyristor are connected to a cathode terminal (K) and the area of the well (P4) included between the cathode regions of the main and auxiliary thyristors is coated with an isolated gate (G2).

3. The monolithic power switch of claim 1, formed in a substrate (N1) of a first conductivity type, the rear surface of which includes a region (P1) of the second conductivity type, **characterized in that** it includes on the upper surface side first cells (N7-P7) of vertical MOS or IGBT type, and second cells combining structures of vertical MOS or IGBT type and a vertical auxiliary thyristor structure, these second cells being formed in regions of the second conductivity type (P8) and containing two rings of the first conductivity type, the first ring (N8) being separated from the second one by a first isolated gate (G2) and being connected to the central portion of said region by a metallization, and the second ring (N9) being separated from the periphery of the region by a second isolated gate (G1) connected to the gate of the first cells.

4. The switch of claim 2 or 3, **characterized in that** it further includes a diode of vertical type (D; P3-N1-N3) biased inversely to the thyristor biasing.

5. The monolithic power switch of claim 1, **characterized in that** the inhibiting means (M) include a MOS transistor connected between the thyristor gate and cathode.

6. The monolithic power switch of claim 5, **characterized in that** it includes means (M1, Z) for self-biasing the MOS transistor.

## Patentansprüche

1. Ein monolithischer Leistungsschalter mit einem gesteuerten di/dt einschließlich der parallelen Anordnung einer Komponente (11, 21, 31) vom MOS oder IGBT Typ mit einer Komponente (12, 32) vom Thyristor-Typ, Mittel (M) beinhaltend zum Sperren der Komponente vom Thyristor-Typ während der Schließphase des Schalters, was sichergestellt wird durch die Komponente vom IGBT Typ, **gekennzeichnet dadurch dass** die Komponente vom IGBT Typ realisiert wird durch eine vertikale Multizellenstruktur und die Komponente vom Thyristor-Typ durch eine vertikale Monozellenstruktur.

2. Monolithischer Leistungsschalter nach Anspruch 1, der in einem Substrat (N1) von einem ersten Leitfähigkeitstyp gebildet ist, wobei dessen Rückoberfläche eine Region (P1) von dem zweiten Leitfähigkeitstyp beinhaltet, **gekennzeichnet dadurch, dass** es auf der oberen Oberflächenseite erste Zellen (N7, P7) des vertikalen MOS oder IGBT Typs, zweite Zellen (N6, P6) des vertikalen MOS oder IGBT Typs und eine Kathoden-Gatter-Wanne des zweiten Leitfähigkeitstyps (P4) die eine Kathodenregion (N4) von einem Haupt-Thyristor und eine Kathodenregion von einem Zusatz- bzw. Hilfs-Thyristor enthält, beinhaltet, wobei die Kathodenregion der zweiten Zellen mit der Kathode und den Kathodengatterregionen des Hilfs-Thyristors verbunden ist, die Kathoden und die Kathodengatterregionen von dem Haupt-Thyristor mit einem Kathodenanschluss (K) verbunden sind, und das Gebiet der Wanne (P4), das zwischen den Kathodenregionen der Haupt- und Hilfs-Thyristoren beinhaltet ist, mit einem isolierten Gatter (G2) beschichtet ist.

3. Monolithischer Leistungsschalter nach Anspruch 1, der in einem Substrat (N1) von einem ersten Leitfähigkeitstyp gebildet ist, dessen Rückoberfläche eine Region (P1) von dem zweiten Leitfähigkeitstyp beinhaltet, **gekennzeichnet dadurch, dass** es auf der oberen Oberflächenseite erste Zellen (N7-P7) vom vertikalen MOS oder IGBT Typ und zweite Zellen die Strukturen vom vertikalen MOS oder IGBT Typ und eine vertikale Zusatz- bzw. Hilfs-Thyristor-Struktur kombinieren, beinhaltet, wobei diese zweiten Zellen in Regionen von dem zweiten Leitfähigkeitstyp (P8) gebildet sind und zwei Ringe von dem ersten Leitfähigkeitstyp enthalten, wobei der erste Ring (N8) von dem zweiten Ring durch ein erstes isoliertes Gatter (G2) separiert ist, und mit dem zentralen Teil von der Region durch eine Metallisierung verbunden ist und der zweite Ring (N9) von der Peripherie von der Region durch ein zweites isoliertes Gatter (G1) separiert ist, das mit dem Gatter von den ersten Zellen verbunden ist.

4. Schalter nach Anspruch 2 oder 3, **dadurch gekennzeichnet dass** er ferner eine Diode vom vertikalen Typ (D; P3-N1-N3) beinhaltet, die invers zu der Thyristor-Vorspannung vorgespannt ist.

5. Monolithischer Leistungsschalter nach Anspruch 1, **dadurch gekennzeichnet, dass** die Hinderungs- bzw. Sperrmittel (M) einen MOS Transistor beinhalten, der zwischen Thyristor-Gatter und -Kathode verbunden ist.

6. Monolithischer Leistungsschalter nach Anspruch 5, **dadurch gekennzeichnet, dass** er Mittel (M1; Z) zum Selbstvorspannen des MOS Transistors beinhaltet.
